# EUROPEAN PATENT APPLICATION

(11) **EP 1 128 435 A2**
(43) Date of publication of application: **29.08.2001**
(21) Application number: 00123415.2
(22) Date of filing: 02.11.2000
(51) Int. Cl.: H01L 23/64, H01L 23/66

(54) **Microwave electric elements using porous silicon dioxide layer and forming method of same**

(30) Priority: 23.02.2000 KR 0008823
(71) Applicant: Telephus Inc., Seoul (KR)
(72) Inventor: Kwon, Young-Se, Daejeon-city (KR)
(74) Representative: Modiano, Guido, Dr.-Ing.

(57) **Abstract**

Disclosed is a microwave element which comprises a silicon substrate, a porous silicon dioxide column formed on the silicon substrate, a silicon column supported by the silicon substrate and having a height identical with that of the porous silicon dioxide column, an active element formed on the silicon column, and a passive element formed on the porous silicon dioxide column and connected to the active element. According to the present invention, elements that have very small signal loss in the microwave ranges over 1GHz can be implemented by using the silicon substrate that has excellent thermal conduction, flatness and is cheap compared to the aluminum substrate.

## Description

### BACKGROUND OF THE INVENTION

### (a) Field of the Invention

The present invention relates to passive electric elements such as inductors, capacitors and resistors formed by using porous oxidized silicon. More specifically, the present invention relates to a microwave passive element for implementing a monolithic microwave integrated circuit (MMIC).

### (b) Description of the Related Art

An MMIC is an analog circuit for processing microwave signals. Since the MMIC is operated in microwave frequencies, the MMIC needs the most advanced techniques in wireless communication, and ranges of wireless connection, battery life, and communication quality depend on the operation of the MMIC.

Silicon substrates are generally used for forming the MMIC since the silicon substrate is cheaper than an aluminum substrate and has higher thermal conductivity, active elements such as transistors and integrated circuits (IC) can be formed directly on the silicon substrate, and semiconductor processing techniques using the silicon substrate are fully developed. However, since it is difficult to obtain a thick insulating layer on the silicon substrate for reducing the signal loss, it is difficult to use the silicon substrate in microwave ranges. The active elements operating in dozens of GHz are developed according to the developments of the processing techniques, but since the passive elements have excessive signal loss, it is difficult to use the silicon substrate over a predetermined frequency. To solve these problems, thick polyimide layers are used or glass material is partially used, but they do not fully solve the problems.

### SUMMARY OF THE INVENTION

It is an object of the present invention to provide a microwave element that operates in the dozens of GHz by preventing signal loss caused by the silicon substrate in the microwave ranges.

In one aspect of the present invention, a microwave element comprises a silicon substrate, a porous silicon dioxide column formed on the substrate, and an element pattern supported by the column.

The element further comprises a first dielectric layer formed on the column and below the element pattern, and the element pattern is an inductor wire.

### BRIEF DESCRIPTION OF THE DRAWINGS

The accompanying drawings, which are incorporated in and constitute a part of the specification, illustrate an embodiment of the invention, and, together with the description, serve to explain the principles of the invention:
FIG. 1 shows a perspective view of an inductor formed by using a porous silicon dioxide layer according to a first preferred embodiment of the present invention;
FIG. 2 shows a perspective view of an inductor formed by using a porous silicon dioxide layer according to a second preferred embodiment of the present invention;
FIG. 3 shows a perspective view of an inductor formed by using a porous silicon dioxide layer according to a third preferred embodiment of the present invention;
FIG. 4 shows a perspective view of a capacitor formed by using a porous silicon dioxide layer according to a fourth preferred embodiment of the present invention;
FIG. 5 shows a perspective view of a capacitor formed by using a porous silicon dioxide layer according to a fifth preferred embodiment of the present invention;
FIG. 6 shows a perspective view of a capacitor formed by using a porous silicon dioxide layer according to a sixth preferred embodiment of the present invention;
FIG. 7 shows a perspective view of a resistor formed by using a porous silicon dioxide layer according to a seventh preferred embodiment of the present invention;
FIG. 8 shows a perspective view of an air bridge formed by using a porous silicon dioxide layer according to an eighth preferred embodiment of the present invention;
FIG. 9 shows a perspective view of a coplanar strip line patch antenna formed by using a porous silicon dioxide layer according to a ninth preferred embodiment of the present invention;
FIG. 10 shows a perspective view of a coplanar strip line patch antenna formed by using a porous silicon dioxide layer according to a tenth preferred embodiment of the present invention; and
FIG. 11 shows a perspective view of an MMIC using passive elements formed with a porous silicon dioxide layer according to a eleventh preferred embodiment of the present invention.

### DETAILED DESCRIPTION OF THE PREFERRED EMBODIMENTS

In the following detailed description, only the preferred embodiments of the invention have been shown and described, simply by way of illustration of the best modes contemplated by the inventor(s) of carrying out the invention. As will be realized, the invention is capable of modification in various obvious respects, all without departing from the invention. Accordingly, the drawings and description are to be regarded as illustrative in nature, and not restrictive.

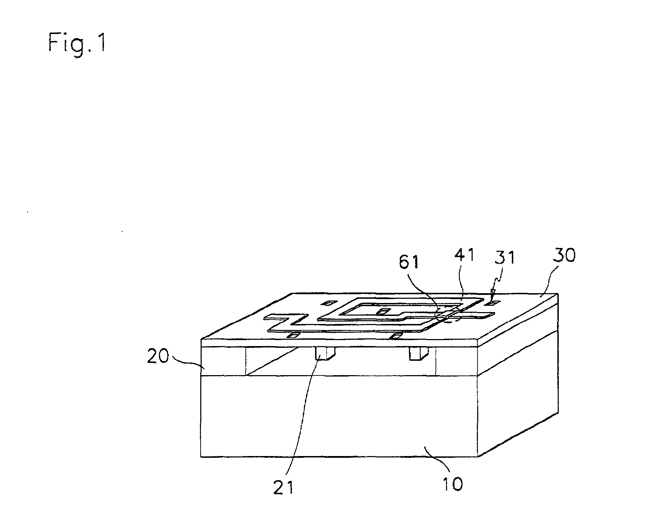

FIG. 1 shows a perspective view of an inductor formed by using a porous oxidized silicon layer according to a first preferred embodiment of the present invention.

Columns 20 and 21 of porous silicon dioxide are formed on a silicon substrate 10, and a thin dielectric layer 30 of material such as silicon nitride, silicon dioxide, SOG or polyimide is formed on the columns 20 and 21. At this time, since the dielectric layer 30 is positioned on the columns 20 and 21, the dielectric layer 30 is separated from the silicon substrate 10, suspended in the air, and the dielectric layer 30 has a plurality of holes 31. An inductor wire 41 of aluminum, titanium or gold is formed on the dielectric layer 30. The inductor wire 41 is spiral, and an air bridge 61 is formed at a point where the inductor wires meet so as to prevent shorting of the inductor wire 41.

Accordingly, most of the electromagnetic field is formed around the inductor wire 41 since the inductor wire 41 is separated from the silicon substrate 10 by the porous silicon dioxide columns 20 and 21. Hence, signal loss by the silicon substrate 10 rarely occurs.

A method for forming the microwave inductor having the above-noted structure will now be described.

A photoresist layer is coated on the silicon layer 10 and then exposed and developed such that only the part for forming the porous silicon dioxide columns 20 and 21 is exposed, and a covering photoresist pattern is formed on a remaining part. The porous silicon layer is formed on the exposed part of the silicon substrate by using the electrical chemical method of bi-polarization, and the porous silicon layer is thermally oxidized again to form the porous silicon dioxide columns 20 and 21.

A photoresist pattern for covering the columns 20 and 21 and the part on which the silicon remains is formed again. The exposed part of the silicon substrate is converted into the porous silicon layer by using the electrical chemical method of bi-polarization.

The inductor wire 41 is formed on the dielectric layer 30 by a plating process which will now be described. First, thin aluminum, titanium or gold is coated on the dielectric layer 30 to form a seed layer on which a photoresist pattern is formed for exposing a part on which the inductor wire will be formed to generate a coating frame. After performing the electrical plating process and removing the photoresist pattern, etching is performed to remove the seed layer, and therefore only the inductor wire 41 with the full thickness of the seed layer remains. The air bridge 61 forms a photoresist pattern that covers the cross section of the inductor wire 41, and the plating process is again performed on the photoresist pattern.

A hole is made through the dielectric layer 30 by photolithography, and an etching material such as NaOH is injected to etch the porous silicon layer so that only the porous silicon dioxide columns 20 and 21 remain.

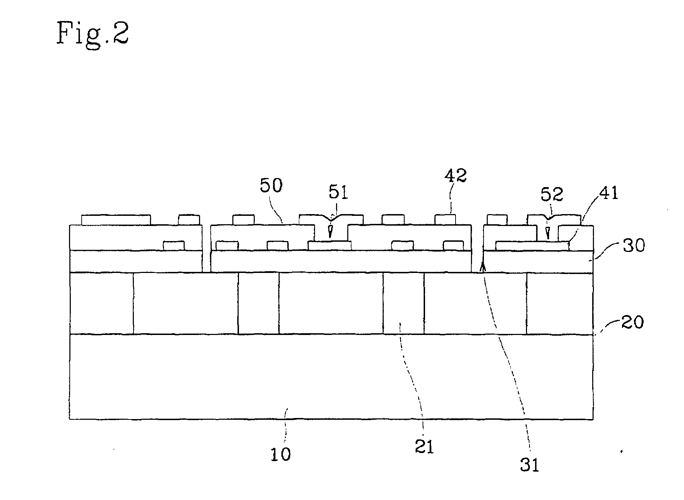

FIG. 2 shows a perspective view of an inductor formed by using a porous silicon dioxide layer according to a second preferred embodiment of the present invention.

Identical with the first preferred embodiment of the present invention as shown in FIG. 1, the inductor according to the second preferred embodiment of the present invention comprises a silicon substrate 10, porous silicon dioxide columns 20 and 21 formed on the silicon substrate 10, a first dielectric layer 30 formed on the columns 20 and 21 and having a hole 31, and a first inductor wire 41 formed on the first dielectric layer 30. The inductor further comprises a second dielectric layer 50 formed on the first inductor wire 41, and a second inductor wire 42 formed on the second dielectric layer 50, and contacting holes 51 and 52 for connecting the first and second inductor wires 41 and 42 are formed. That is, the second preferred embodiment forms the inductor layers 41 and 42 in two layers and increases the length of the inductor wires to increase the inductance.

A method for forming the inductor is almost identical with the first preferred embodiment, and a process for forming the second dielectric layer 50 and the second inductor wire 42 is added, which is identical with the process for forming the first dielectric layer 30 and the first inductor wire 41. At this time, it is preferable to form the hole 31 for injection of the etching material such as NaOH together with the contacting holes 51 and 52, for simplifying the process. That is, if the hole 31 is formed when forming the contacting holes 51 and 52 at the second dielectric layer 50 before forming a second metal wire after forming the second dielectric layer 50, a number of times of applying the photolithography can be reduced.

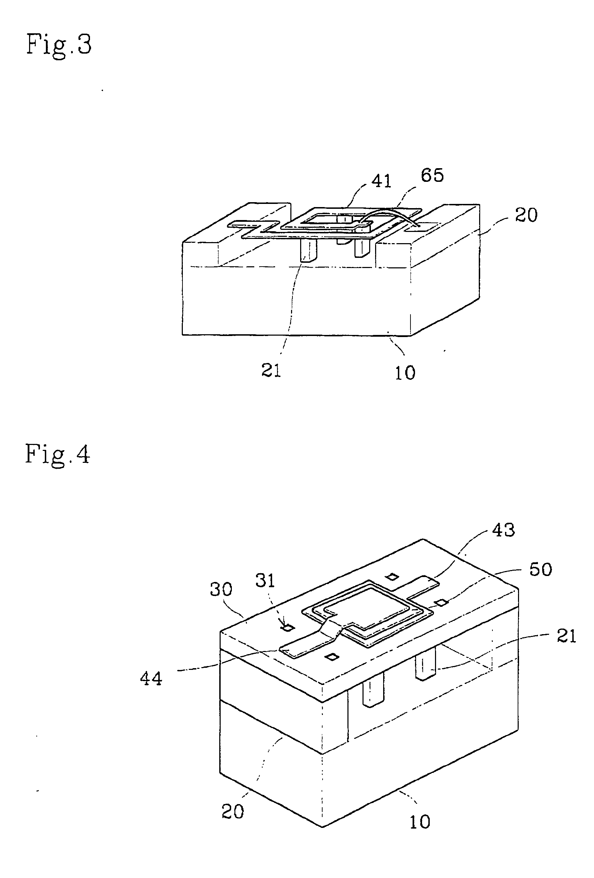

FIG. 3 shows a perspective view of an inductor formed by using a porous silicon dioxide layer according to a third preferred embodiment of the present invention.

In the third preferred embodiment, the dielectric layer 30 under the inductor wire 41 of the first preferred embodiment is removed, and the shorting of the inductor wire 41 is prevented via wire bonding 65 instead of forming the air bridge.

A method for forming the inductor of the above-noted structure will now be described.

The silicon substrate 10 is patterned via photolithography so as to form silicon columns.

The silicon columns are converted into porous silicon columns via the electrical chemical bi-polarization method, and then thermally oxidized to form the porous silicon dioxide columns 20 and 21. At this time, it may be that no processing is provided to the porous silicon dioxide columns, or they can be selectively formed by applying the electrical chemical method, thermal oxidization, and etching after forming the photoresist pattern.

An empty area around the columns 20 and 21 is filled with a dielectric substance of low permittivity so the surface becomes flat, a seed metal layer is deposited on the columns, a photoresist layer pattern is formed to generate a coating frame, and then the columns are coated with metal. Next, the wire is bonded. The photoresist layer pattern, that is, the coating frame is removed, and the metal is totally etched, and therefore the seed metal layer is removed and the inductor wire 41 is formed, and either the dielectric substance that fills the columns 20 and 21 is removed or a dielectric substance with low permittivity is additionally coated on the inductor wire 41.

Therefore, signal interference caused by the bridge of the first preferred embodiment can be reduced and a higher Q factor can be obtained and serial capacitance can be reduced.

FIG. 4 shows a perspective view of a capacitor formed by using a porous silicon dioxide layer according to a fourth preferred embodiment of the present invention.

The silicon substrate 10, the porous silicon dioxide columns 20 and 21, and the dielectric layer 30 of the fourth preferred embodiment are identical with the first preferred embodiment, and differently, first and second electrodes 43 and 44 for forming capacitance are formed on the dielectric layer 30 instead of the inductor wire, and a second dielectric layer is formed between the first and second electrodes 43 and 44.

Accordingly, a capacitor having a capacitance over several pFs can be formed. At this time, the capacitance depends on the square area of the first and second electrodes 43 and 44, thickness of the dielectric layer, and permittivity.

In the method for forming the capacitor having the above-noted structure, the method for forming the porous silicon dioxide columns 20 and 21 is identical with the first preferred embodiment. Further, the first electrode 43 is formed by the plating process instead of the inductor wire forming process, and the second dielectric layer 50 is formed by depositing the dielectric layer on the first electrode 43 and by the photolithography, and the plating process is again performed so as to form the second electrode 44.

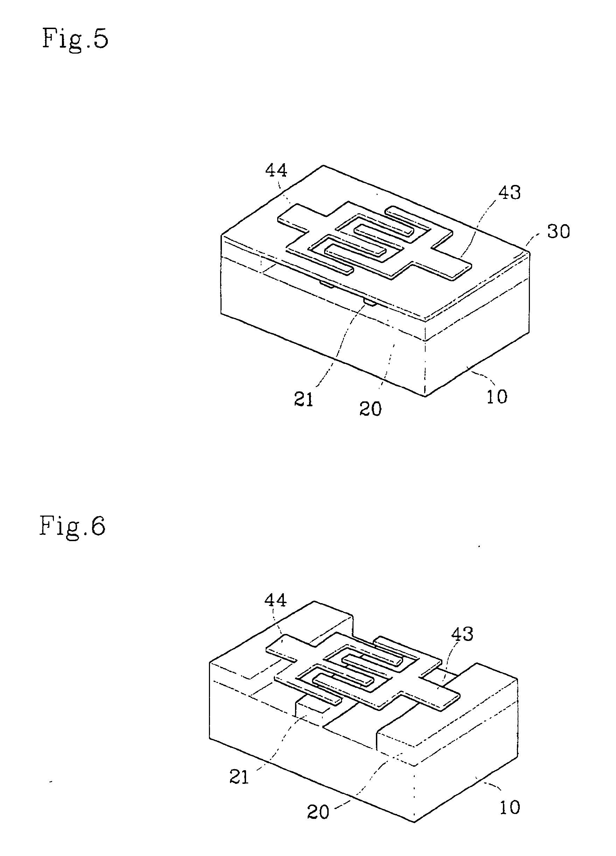

FIG. 5 shows a perspective view of a capacitor formed by using a porous silicon dioxide layer according to a fifth preferred embodiment of the present invention.

The silicon substrate 10, the porous silicon dioxide columns 20 and 21, and the dielectric layer 30 are identical with the first preferred embodiment, and differently, the two electrodes 43 and 44 for forming the capacitance are separately formed on the dielectric layer 30. At this time, the electrodes each have a plurality of branch electrodes which are alternately formed so as to increase the square area superimposed between the electrodes 43 and 44 and increase the capacitance. Here, the capacitance depends on the number of the branch electrodes, and length of the superimposed branch electrodes. The capacitor of the above-noted structure is mainly used in elements that require capacitance below several pFs.

Since this type of capacitor can be formed via the method of forming the inductor of the first preferred embodiment, the capacitor of the fifth preferred embodiment has a simpler forming process compared to the fourth preferred embodiment.

FIG. 6 shows a perspective view of a capacitor formed by using a porous silicon dioxide layer according to a sixth preferred embodiment of the present invention.

In the capacitor of the sixth preferred embodiment, the dielectric layer 30 of the fifth preferred embodiment is not used. Since most of the electromagnetic field formed around the two electrodes 43 and 44 is in the air, parasitic elements can be minimized.

The capacitor of the above-noted structure can be formed with the method identical with that for forming the inductor of the third preferred embodiment.

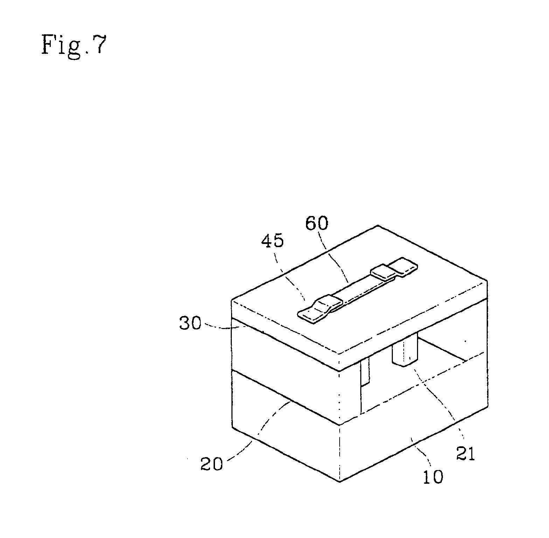

FIG. 7 shows a perspective view of a resistor formed by using a porous silicon dioxide layer according to a seventh preferred embodiment of the present invention.

The silicon substrate 10, the porous silicon dioxide columns 20 and 21, and the dielectric layer 30 are identical with the first preferred embodiment, and differently, a resistance pattern 60 of material having high resistance such as Nichrome is formed on the dielectric layer 30, and metal wire 45 for connection to other elements is formed on both ends of the resistance pattern 60. At this time, the metal wire 45 is made of aluminum, titanium or gold.

The above-noted process is identical with that of the first preferred embodiment excepting that the Nichrome is deposited and patterned on the dielectric layer 30 by a high vacuum deposition method so as to form the resistance pattern 60, and then the metal wire 45 is formed via the plating process.

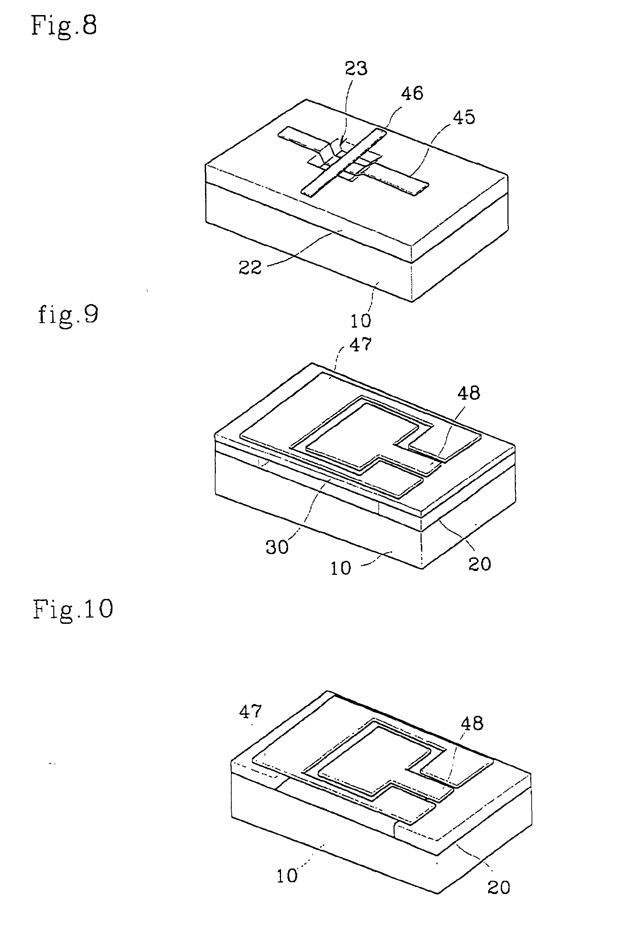

FIG. 8 shows a perspective view of an air bridge formed by using a porous silicon dioxide layer according to an eighth preferred embodiment of the present invention.

A porous silicon dioxide layer 22 is formed on the silicon substrate 10, and the metal wires 45 and 46 cross on the porous silicon dioxide layer 22. At this time, a concave portion 23 is formed on the porous silicon dioxide layer 22, and the metal wires 45 and 46 cross on the concave portion 23. Since the first metal wire 45 is formed along the bottom surface of the concave portion 23 and the second metal wire 46 is placed over the concave portion 23, the two metal wires 45 and 46 are separated.

A method for forming the air bridge will now be described.

The silicon substrate 10 is selectively etched to form the concave portion 23, and the silicon substrate 10 is converted into the porous silicon dioxide layer 22 via bipolar oxidization and thermal oxidization.

The first wire 45 is formed through the plating process, and the dielectric substance is filled in the concave portion so that it becomes flat, and the plating process is performed again to form the second wire 46, and the dielectric substance is additionally coated on the second wire 46 so as to remove or protect the dielectric substance provided in the concave portion.

FIG. 9 shows a perspective view of a coplanar strip line patch antenna formed by using a porous silicon dioxide layer according to a ninth preferred embodiment of the present invention.

The silicon substrate 10, the porous silicon dioxide column 20, and the dielectric layer 30 have the same structure as the first preferred embodiment. A metallic antenna pattern 48 and a metal ground 47 are formed on the dielectric layer 30.

A method for forming the above-noted coplanar strip line patch antenna is identical with that of the first preferred embodiment.

FIG. 10 shows a perspective view of a coplanar strip line patch antenna formed by using a porous silicon dioxide layer according to a tenth preferred embodiment of the present invention.

The coplanar strip line patch antenna of the tenth preferred embodiment does not have the dielectric layer 30 of the ninth preferred embodiment.

The method for forming the coplanar strip line patch antenna is identical with that of the third preferred embodiment.

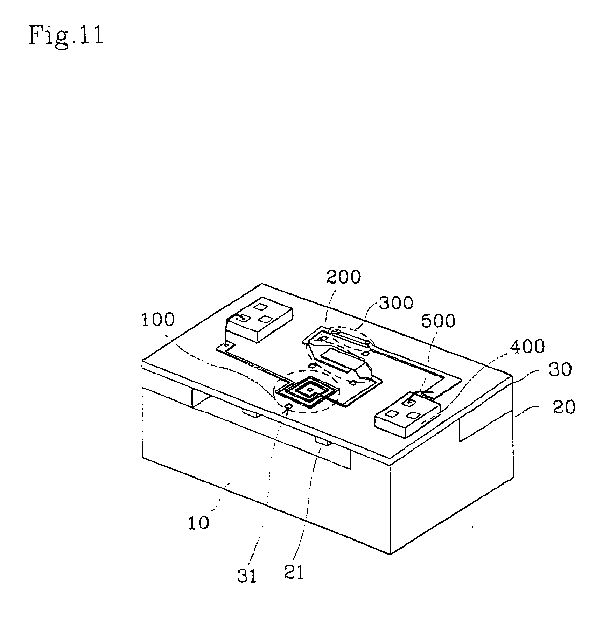

FIG. 11 shows a perspective view of an MMIC made by using passive elements formed by using a porous silicon dioxide layer according to an eleventh preferred embodiment of the present invention.

The porous silicon dioxide columns 20 and 21 are formed on the silicon substrate 10. At this time, some parts of the columns are porous-silicon-oxidized and some parts are silicon. The dielectric layer 30 having the holes 31 are formed on the porous silicon dioxide columns 20 and 21. Passive elements such as an inductor 100, a capacitor 200 and a resistor 300 formed on the dielectric layer 30 are connected via the metal wire, and an active element 400 is formed on the silicon column. The active element 400 is connected to the passive element via wire bonding or flip chip bonding.

If necessary, no dielectric layer 30 is formed below the active element.

As noted above, since the passive element is separated from the silicon substrate having heavy loss and formed beyond the substrate, severe signal loss can be prevented even when the passive elements are driven at the microwaves.

FIG. 11 is a simplified diagram for explanation of the present invention, and therefore the actual MMIC will be very complicated.

According to the present invention, elements that have very small signal loss in the microwave ranges over 1GHz can be implemented by using the silicon substrate that has excellent thermal conduction and flatness, and it is cheap compared to the aluminum substrate.

While this invention has been described in connection with what is presently considered to be the most practical and preferred embodiment, it is to be understood that the invention is not limited to the disclosed embodiments, but, on the contrary, is intended to cover various modifications and equivalent arrangements included within the spirit and scope of the appended claims.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. A microwave element comprising:
a silicon substrate;
a porous silicon dioxide column formed on the substrate; and
an element pattern supported by the column.

2. The element of claim 1, wherein the element further comprises a first dielectric layer formed on the column and below the element pattern.

3. The element of claim 1, wherein the element pattern is an inductor wire.

4. The element of claim 1, wherein the element pattern comprises first and second electrodes, each of which is separated and faces the opposite one, and the first and second electrodes each have a plurality of branch electrodes, and the branch electrodes of the first and second electrodes are alternately provided.

5. The element of claim 1, wherein the element pattern is a resistance pattern.

6. The element of claim 1, wherein the element pattern comprises an antenna pattern and a ground that surrounds the antenna pattern.

7. The element of claim 1, wherein the element pattern comprises a first electrode, a second electrode formed on the first electrode and facing the first electrode, and a second dielectric layer provided between the first and second electrodes and insulating the first and second electrodes.

8. The element of claim 1, wherein the element pattern comprises a first inductor wire, a second dielectric layer formed on the first inductor wire and having a contacting hole that exposes the first inductor wire, and a second inductor wire formed on the second dielectric layer and connected to the first inductor wire through the contacting hole.

9. A microwave element comprising:
a silicon substrate;
a porous silicon dioxide column formed on the silicon substrate;
a silicon column supported by the silicon substrate and having a height identical with that of the porous silicon dioxide column;
an active element formed on the silicon column; and
a passive element formed on the porous silicon dioxide column and connected to the active element.

10. The element of claim 9, wherein the element further comprises a first dielectric layer formed on the column and below an element pattern.

11. A microwave element comprising:
a silicon substrate;
a silicon column formed on the silicon substrate;
an active element formed on the silicon column;
a dielectric layer supported by the silicon column; and
a passive element formed on the dielectric layer and connected to the active element.

12. A microwave element comprising:
a silicon substrate;
a porous silicon dioxide layer formed on the silicon substrate and having a concave portion;
a first wire formed along the bottom surface of the concave portion; and
a second wire placed over the concave portion.

13. The element of claim 12, wherein a substance material of low permittivity is added on the surface of the element so as to protect the element.

14. A microwave element forming method comprising the steps of:
forming a porous silicon dioxide layer and a porous silicon layer on a silicon substrate;
forming a dielectric layer on the porous silicon dioxide layer and the porous silicon layer;
forming an element pattern on the dielectric layer; and
forming a hole on the dielectric layer and injecting an etching material through the hole and partially etching the porous silicon dioxide layer.

15. A microwave element forming method comprising the steps of:
forming a porous silicon dioxide layer and a porous silicon layer on a silicon substrate;
forming an element pattern on the porous silicon dioxide layer; and
injecting an etching material between the element pattern and partially etching the porous silicon dioxide layer.

16. A microwave element forming method comprising the steps of:
patterning a silicon substrate and forming a column;
converting at least a part of the column into a porous silicon dioxide;
adding a predetermined material on the surface of the column and flattening the surface; and
forming an element pattern.

17. The method of claim 16, wherein the predetermined material is a dielectric substance.

18. A microwave element forming method comprising the steps of:
forming a concave portion on a silicon substrate;
converting an upper part of the silicon substrate including the concave portion into a porous silicon dioxide layer;
forming a first wire passing through the concave portion on the porous silicon dioxide layer;
adding a predetermined material in the concave portion ; and
forming a second wire passing over the predetermined material.
